# EUROPÄISCHE PATENTSCHRIFT

(11) **EP 3 048 869 B1**
(45) Veröffentlichungstag und Bekanntmachung des Hinweises auf die Patenterteilung: **04.03.2020**
(21) Anmeldenummer: 16151336.1
(22) Anmeldetag: 14.01.2016
(51) Int. Cl.: H05K 7/20, G06F 1/20

(54) **RECHENZENTRUM**
COMPUTER CENTRE
CENTRE DE CALCUL

(30) Priorität: 23.01.2015 DE 102015101022
(43) Veröffentlichungstag der Anmeldung: 27.07.2016
(73) Patentinhaber: Rittal GmbH & Co. KG, 35745 Herborn (DE)
(72) Erfinder: Nicolai, Michael, 35466 Rabenau (DE); Nonn, Helmut, 57629 Malberg (DE)
(74) Vertreter: Angerhausen, Christoph

(56) Entgegenhaltungen:
- US-A1- 2015 156 926

## Beschreibung

Die Erfindung geht aus von einem Rechenzentrum, bei dem in einem geschlossenen Raum eine Mehrzahl aus jeweils mehreren Schaltschränkten gebildeter Schaltschrankreihen sowie mindestens ein Kühlgerät auf einem Doppelboden aufgestellt sind. In den Doppelboden ist über das Kühlgerät gekühlte Raumluft eingeleitet, wobei zwischen zwei benachbarten Schaltschrankreihen ein gegenüber dem Raum luftdicht abgeschotteter Kaltgang gebildet ist, dem die gekühlte Luft aus dem Doppelboden zugeführt wird. Den Schaltschränken der benachbarten Schaltschrankreihen ist jeweils an ihren dem Kaltgang zugewandten Vertikalseiten die gekühlte Luft zugeleitet, die als erwärmte Luft an gegenüberliegenden, dem Kaltgang abgewandten Vertikalseiten der Schaltschränke in den Raum abgeleitet wird. Das Kühlgerät weist einen ersten Luft-Flüssigkeit-Wärmetauscher auf, dem ein über mindestens einen außerhalb des Raums angeordneten Rückkühler gekühltes Kühlmittel zugeleitet ist. Ein derartiges Rechenzentrum ist beispielsweise aus der US 2010/0252233 A1 bekannt. Ähnliche Rechenzentren zeigen auch die US 2015/0156926 A1, die EP 2 532 217 B1, die EP 1 466 234 B1, die DE 10 2011 000638 A1 und die US 2010/0275618 A1.

Gattungsgemäße Rechenzentren haben häufig den Nachteil, dass es mit einem hohen Aufwand verbunden ist, nachträglich abweichend von der ursprünglichen Rechenzentrumsplanung die Kühlleistung zu erhöhen, etwa weil zu einem späteren Zeitpunkt ein höherer Kühlleistungsbedarf notwendig geworden ist. Dies liegt insbesondere daran, dass die in den Rechenzentren vorgesehenen Kühlgeräte häufig nur einen beschränkten Bauraum einnehmen dürfen, oder ihnen bei der Rechenzentrumplanung ein fester Bauraum zugewiesen worden ist, welcher nachträglich nicht zur Erhöhung der Kühlleistung beliebig erweitert werden kann.

Es ist daher die Aufgabe der Erfindung, ein Rechenzentrum vorzuschlagen, welches eine nachträgliche Kühlleistungserhöhung erlaubt.

Die Aufgabe der Erfindung wird durch ein Rechenzentrum mit den Merkmalen des Anspruchs 1 gelöst. Die abhängigen Ansprüche betreffen jeweils vorteilhafte Ausführungsformen der Erfindung.

Demgemäß zeichnet sich ein erfindungsgemäßes Rechenzentrum dadurch aus, dass mindestens einer der Schaltschränke einen unmittelbar auf seiner Oberseite oder unter einem Abstand dazu montierten zweiten Luft-Flüssigkeits-Wärmetauscher aufweist, durch den Warmluft aus dem Raum als gekühlte Luft in den Kaltgang geleitet ist, wobei dem zweiten Luft-Flüssigkeit-Wärmetauscher über eine außerhalb des Raums angeordnete Kühlmittelquelle gekühltes Kühlmittel zugeleitet ist, wobei der zweite Luft-Flüssigkeits-Wärmetauscher in einem auf der Oberseite des betreffenden Schaltschranks montierten Kühlgehäuse aufgenommen ist, wobei durch gegenüber liegende Gehäuseseiten des Kühlgehäuses die Warmluft aus dem Raum durch das Kühlgehäuse und als gekühlte Luft in den Kaltgang geleitet ist, und wobei in dem Kühlgehäuse mindestens ein drehzahlgeregelter Lüfter aufgenommen ist, wobei an einem Warmlufteinlass und/oder an einem Kaltluftauslass des Kühlgehäuses eine Vorrichtung, etwa eine Rückstauklappe oder ein Jalousieklappenmodul, angeordnet ist, welche dazu eingerichtet ist, ein Zurückströmen von gekühlte Luft aus dem Kaltgang in den Raum zu verhindern.

Die Erfindung macht sich somit den Umstand zu Nutze, dass bei bestehenden Rechenzentren in der Regel oberhalb der Schaltschrankreihen ungenutzter Bauraum zur Verfügung steht. In der Regel wird dieser Bauraum schon deshalb bei der Rechenzentrumsplanung mitberücksichtigt, weil bei gängigen Rechenzentren die Verkabelung der Schaltschränkte für die Daten- und Energiezufuhr häufig zumindest teilweise durch die Oberseite der Schaltschränke hindurch ausgeführt ist.

Da folglich bei erfindungsgemäßen Rechenzentren die erforderliche Kühlleistung nicht mehr ausschließlich von dem bereits vorhandenen Kühlgerät erbracht werden muss, sondern dieses durch den zweiten Luft-Flüssigkeits-Wärmetauscher unterstützt wird, kann die Vorlauftemperatur des vorhandenen Kühlgerätes erhöht werden, so dass sich dessen Wirkungsgrad erhöht. Dieser kann noch dadurch verbessert werden, dass der Rückkühler als ein Freikühler oder Chiller ausgebildet ist, so dass insbesondere in den Sommermonaten aufgrund der dann immer noch ausreichend hohen Temperaturdifferenz zwischen Vorlauftemperatur und Außentemperatur über den Rückkühler eine ausreichende Kühlleistung bereitgestellt werden kann.

Der zweite Luft-Kühlmittel-Wärmetauscher kann beispielsweise ein schräg eingebauter Wärmetauscher sein, der für den Betrieb mit einem Glykol-Wasser-Gemisch und Vorlauftemperaturen von >22° C und vorzugsweise von 26° C ausgelegt ist.

Die Kühlmittelquelle, mithilfe welcher dem zweiten Luft-Kühlmittel-Wärmetauscher gekühltes Kühlmittel zugeleitet wird, ist auf keine bestimmten Ausführungsformen beschränkt. Besonders bevorzugt sind jedoch Kältemaschinen mit Freikühlung. Bei einer Ausführungsform der Erfindung weist der Rückkühler, über den dem ersten Luft-Kühlmittel-Wärmetauscher gekühltes Kühlmittel bereitgestellt ist, mindestens einen Freikühler auf. Bei noch einer anderen Ausführungsform weist die Kühlmittelquelle, über die dem zweiten Luft-Kühlmittel-Wärmetauscher gekühltes Kühlmittel zugeleitet ist, mindestens einen Rückkühler und/oder einen Kaltwassersatz auf.

Erfindungsgemäß ist der zweite Luft-Flüssigkeit-Wärmetauscher in einem auf der Oberseite des betreffenden Schaltschrankes montierten Kühlgehäuses aufgenommen, wobei durch gegenüberliegende Gehäuseseiten des Kühlgehäuses die Warmluft aus dem Raum durch das Kühlgehäuse und als gekühlte Luft in den Kaltgang geleitet ist. Zur Luftförderung können EC-Ventilatoren in Form von Axiallüftern eingesetzt werden. Dabei kann vorgesehen sein, dass die Lüfter in Blechkassetten eingebaut als Lüftermodule und mit Steckerkontakten zur Betriebsstrom- und Signalübertragung ausgebildet sind.

Bei noch einer anderen Ausführungsform der Erfindung ist vorgesehen, dass nur eine der beiden benachbarten, dem Kaltgang zwischen sich bildenden Schaltschrankreihen mindestens einen Schaltschrank mit auf seiner Oberseite montiertem zweiten Luft-Flüssigkeits-Wärmetauscher aufweist, wobei die den Kaltgang bildenden Schaltschrankreihen im Wesentlichen dieselbe Höhe aufweisen, und wobei eine Kaltgangschottung zumindest abschnittsweise eine Höhe aufweist, die mindestens der Gesamthöhe aus Schaltschrankhöhe und Kühlgehäusehöhe entspricht. Dabei kann die Kaltgangschottung derart ausgebildet sein, dass sie die obere Dachseite des Kühlgehäuses mit der Oberseite der gegenüberliegenden Schaltschrankreihe fluidisch dicht verbindet. Dabei wird somit über die Kaltgangschottung der Höhenunterschied zwischen der oberen Dachseite des Kühlgehäuses und der Oberseite der gegenüberliegenden Schaltschrankreihe ausgeglichen, so dass trotz dieses Höhenunterschieds der Kaltgang fluidisch dicht gegenüber dem Raum des Rechenzentrums abgeschottet ist.

Bei noch einer anderen Ausführungsform der Erfindung weisen der das Kühlgehäuse aufweisende Schaltschrank sowie das Kühlgehäuse ein aus vier Vertikalstreben und acht Horizontalstreben gebildetes Rahmengestell auf, wobei sich die Vertikalstreben über die Gesamthöhe aus Schaltschrank und Kühlgehäuse erstrecken. Bei dieser Ausführungsform ist somit für Schaltschrank als auch Kühlgehäuse ein einheitliches Rahmengestell gebildet, so dass die Last des Kühlgehäuses oberhalb des Schaltschranks sicher gehalten ist. Darüber hinaus ist denkbar, dass das Kühlgehäuse entweder ein eigenes oder kein Rahmengestell aufweist, wobei in beiden Fällen dann sichergestellt werden muss, dass die Last des Kühlgehäuses auf die vertikalen Profilstreben übertragen wird, so dass das Kühlgehäuse sicher auf den Schaltschrank gehalten ist.

Bei einer weiteren Ausführungsform der Erfindung ist das Kühlgehäuse unter einem Abstand zu der Oberseite des Schaltschranks angeordnet, so dass zwischen der Oberseite des Schaltschranks und dem Kühlgehäuse ein Kabelrangierraum für eine Kabelzuführung durch die Oberseite des Schaltschranks in den Innenraum des Schaltschranks ausgebildet ist.

Der Luftdurchtritt durch das Kühlgehäuse erfolgt vorzugsweise durch die gegenüberliegenden Stirn- bzw. Frontseiten. Um eine Rückströmung gekühlter Luft bei Gerätestillstand zu vermeiden, kann ein Jalousieklappmodul vorgesehen sein. Wahlweise kann das Jalousieklappenmodul fremdenergielos arbeitende, per Überdruck betätigte Lamellen aufweisen, oder aber eine Jalousieklappe mit gegenläufigen Lamellen und Klappenstellantrieb. Der Einsatz eines solchen Moduls kann insbesondere immer dann erforderlich sein, wenn das Kühlgehäuse mit dem zweiten Luft-Kühlmittel-Wärmetauscher als funktionale Redundanz zu dem ohnehin vorhandenen Kühlgerät eingesetzt werden soll oder ein anderes Klimasystem mit differenter Luftführung als Redundanzsystem betrieben werden soll. Es ist daher vorgesehen, dass in dem Kühlgehäuse mindestens ein drehzahlgeregelter Lüfter aufgenommen ist, wobei an einem Warmlufteinlass und/oder an einem Kaltluftauslass des Kühlgehäuses eine Vorrichtung, etwa eine Rückstauklappe oder ein Jalousieklappenmodul, angeordnet ist, welche darauf ausgelegt ist, ein Zurückströmen von gekühlter Luft aus dem Kaltgang in den Raum zu verhindern.

Zur weiteren Erhöhung der Redundanz und um abhängig von der Außentemperatur jeweils eine bestmögliche, das heißt effizienteste Kühlung zu erreichen, ist bei einer Ausführungsform der Erfindung vorgesehen, dass die Kühlmittelquelle, über die dem zweiten Luft-Flüssigkeits-Wärmetauscher Kühlmittel zugeleitet ist, mindestens einen Rückkühler und mindestens einen Kaltwassersatz aufweist, die über eine Dreiwegeventil oder Dergleichen fluidisch mit dem zweiten Luft-Flüssigkeitswärmetauscher verbunden sind.

Zur Optimierung der Luftführung ist bei einer Ausführungsform der Erfindung vorgesehen, dass das Kühlgehäuse an seiner Luftausströmseite für gekühlte Luft eine Luftleitgeometrie aufweist, über die die aus dem Kühlgehäuse in den Kaltgang einströmende, gekühlte Luft vor die benachbarte Schaltschrankreihe geblasen wird, um dort effektiv in die Schaltschränke eingeleitet werden zu können.

Es ist bekannt, dass sich insbesondere im Deckenbereich eines Rechenzentrums die Warmluft staut, so dass sich dort Warmluftpolster ausbilden. Bei einer Ausführungsform der Erfindung ist daher vorgesehen, dass der Raum des Rechenzentrums eine Deckenhöhe aufweist, die nur unwesentlich höher als die Höhe der kombinierten Einheit aus Schaltschrank und darauf montiertem, zweiten Luft-Flüssigkeits-Wärmetauscher ist, so dass durch den zweiten Luft-Flüssigkeits-Wärmetauscher Luft eines unter der Raumdecke stehenden Warmluftpolsters geleitet ist.

Weitere Einzelheiten der Erfindung werden anhand der nachstehenden Figuren erläutert. Dabei zeigt:
Figur 1 eine Ausführungsform des erfindungsgemäßen Rechenzentrums in schematischer Darstellung;
Figur 2 eine erste Anordnung aus zwei benachbarten Schaltschrankreihen, zwischen denen ein Kaltgang ausgebildet ist;
Figur 3 eine zweite Ausführungsform einer Schaltschrankanordnung, bei der zwischen zwei Schaltschrankreihen ein Kaltgang ausgebildet ist; und
Figur 4 zwei Ausführungsformen einer Schaltschrankreihe für ein erfindungsgemäßes Rechenzentrum mit unterschiedlicher Kühlleistungsauslegung.

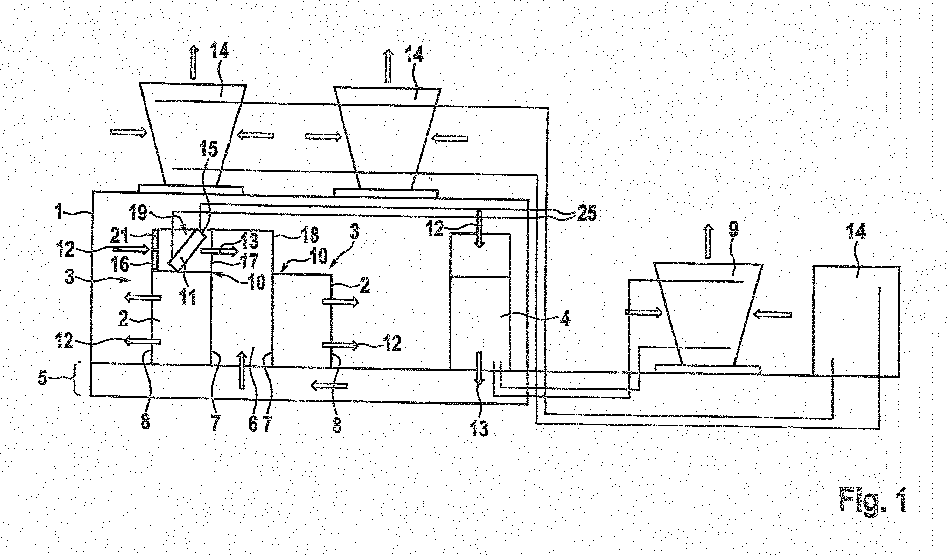

Bei dem in Figur 1 dargestellten Rechenzentrum sind der Einfachheit halber lediglich die für die Erfindung wesentlichen Komponenten dargestellt. Beispielsweise sind lediglich zwei Schaltschankreihen 3 in dem geschlossenen Raum 1 des Rechenzentrums abgebildet. Üblicherweise weist ein Rechenzentrum eine Vielzahl Schaltschrankreihen auf, wobei jeweils zwischen Paaren von zwei benachbarten Schaltschrankreihen ein Kaltgang ausgebildet ist. Bei einer Abfolge von mehreren nebeneinander angeordneten Schaltschrankreihen sind die Schaltschrankreihen immer so ausgerichtet, dass sich zwischen den Schaltschrankreihen abwechselnd ein Kaltgang und ein Warmgang ausbildet. Wenn also, wie es in Figur 1 dargestellt ist, die Warmluft unmittelbar aus den Schaltschränken 2 der Schaltschrankreihen 3 in den Raum 1 eingeblasen wird, so sind grundsätzlich auch Ausführungsformen denkbar, bei denen in zuvor beschriebener Weise Warmgänge ausgebildet sind, aus denen die Warmluft in den Raum des Rechenzentrums abgeleitet wird.

Wie in Figur 1 zu erkennen ist, bilden die Schaltschrankreihen 3, die jeweils aus mehreren Schaltschränken 2 ausgebildet sind, zwischen sich einen Kaltgang 6 aus, wozu die Schaltschränke 2 der benachbarten Schaltschrankreihen jeweils so zueinander angeordnet sind, dass ihre Kaltlufteinlassseiten im Kaltgang 6 und damit einander zugewandt sind.

Die in der Darstellung linke Schaltschrankreihe 3 weist auf ihrer Oberseite 10 ein Kühlgehäuse 19 auf, indem ein schräg gestellter Luft-Kühlmittel-Wärmetauscher aufgenommen ist. Der Wärmetauscher 11 ist über ein Leitungssystem mit außerhalb des Raums 1 angeordneten Kühlmittelquellen 14 fluidisch verbunden. Die Kühlmittelquellen 14 können beispielsweise Freikühler oder ein Kaltwassersatz sein. Über ein Dreiwegeventil 25 kann, beispielsweise abhängig von der Außentemperatur, gesteuert werden, ob das Kühlmittel für den Luft-Flüssigkeits-Wärmetauscher 11 über die eine oder die andere Kühlmittelquellenbauart bereitgestellt wird.

Die Schaltschrankreihen 3 sowie das Kühlgerät 4, welches beispielsweise einen Kältekompressor, einen Direktverdampfer und einen integrierten Luft-Flüssigkeits-Wärmetauscher für Freikühlung aufweisen kann, sind auf einem Doppelboden 5 angeordnet. Das Kühlgerät 4 saugt Warmluft aus dem Rechenzentrumsraum 1 an, welche es kühlt und als gekühlte Luft in den Doppelboden 5 einleitet. Die gekühlte Luft wird aus dem Doppelboden 5 in den Kaltgang 6 eingeleitet. Die Kühlluft kann daraufhin durch die Schaltschränke hindurch geleitet werden und tritt an den dem Kaltgang 6 abgewandten Schaltschrankseiten 8 als erwärmte Luft 12 in den Raum 1 aus.

Ein Teil dieser erwärmten Luft wird durch das Kühlgehäuse 15 und den Luft-Kühlmittel-Wärmetauscher 11 geleitet, um als gekühlte Luft 13 unmittelbar in den Kaltgang 6 eingeleitet zu werden. Ein anderer Teil der erwärmten Luft wird in der zuvor beschriebenen Weise durch das Kühlgerät 4 gekühlt und durch den Doppelboden 5 in den Kaltgang 6 geleitet.

In dem Gehäuse 15 sind drehzahlgeregelte Lüfter 21 aufgenommen, mithilfe welcher Warmluft 12 aus dem Raum 1 über die Gehäuseseite 16 angesogen, durch den Luft-Flüssigkeits-Wärmetauscher 11 hindurchgeleitet und an der gegenüberliegenden Seite 17 des Kühlgehäuses 15 in den Kaltgang 6 eingeleitet wird.

Der Figur 1 ist weiterhin zu entnehmen, dass eine Abschottung gerade so ausgebildet ist, dass sie eine fluidisch dichte Verbindung zwischen der Oberseite 19 des Gehäuses 15 und der Oberseite 10 des Schaltschranks 2 der gegenüberliegenden Schaltschrankreihen 3 herstellt. An der Luftaustrittsseite 17 des Gehäuses 15 ist eine Luftgleitgeometrie (nicht dargestellt), etwa unter Verwendung von Luftleitblechen ausgebildet, mit Hilfe welcher die austretende, gekühlte Luft 13 auf die gegenüberliegende Schaltschrankreihe 3 zugeleitet wird.

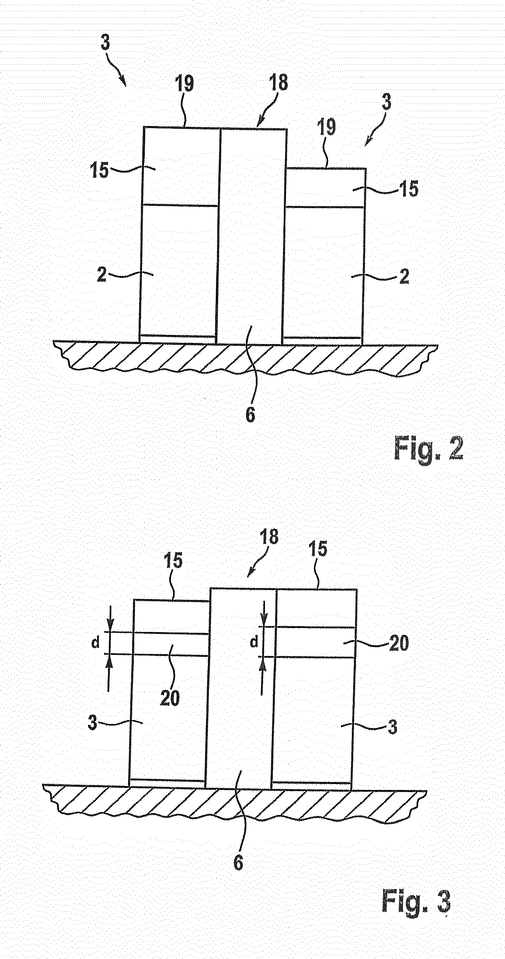

In der Figur 2 ist dargestellt, dass je nach zusätzlich erforderlicher Kühlleistung die Bauhöhe des Kühlgehäuses 15 und damit die Größe des darin aufgenommen Luft-Kühlmittel-Wärmetauschers 11 variiert werden kann. Es ist ebenfalls zu erkennen, dass auch vorgesehen ist, dass beide der gegenüberliegenden Schaltschrankreihen 3 Schaltschränke 2 mit auf ihrer Oberseite angeordneten Kühlgehäusen 15 für die Bereitstellung zusätzlicher Kühlleistung aufweisen können. Abhängig davon, wie diese zusätzlichen Kühlgehäuse 15 konfektioniert sind und wie dementsprechend ihre Bauhöhe ausfällt, ist die Schottung 18 des Kaltgangs 6 wiederum dazu ausgebildet, eine fluidisch dichte Verbindung der Oberseiten 19 der gegenüberliegenden Kühlgehäuse 15 bereitzustellen.

Die Figur 3 zeigt eine Ausführungsform, bei der die Kühlgehäuse 15 unter einem Abstand d zu den darunterliegenden Schaltschränken 3 angeordnet sind. Dadurch wird zwischen dem jeweiligen Schaltschrank 3 und dem jeweiligen Kühlgehäuse 15 ein Kabelrangierraum 20 gebildet, welcher die Kabelzuführung in den Schaltschrankinnenraum in gewohnter Weise durch die Oberseite des Schaltschranks hindurch ermöglicht.

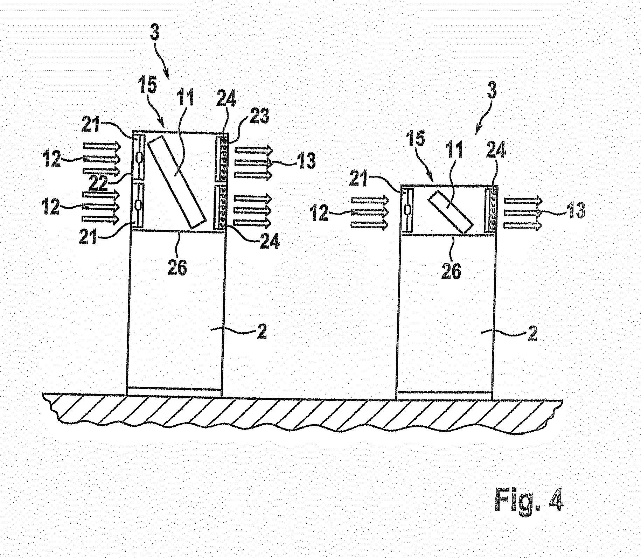

In Figur 4 ist veranschaulicht, dass je nach Kühlleistungsbedarf unterschiedliche Bauhöhen des Kühlgehäuses 15 vorgesehen sein können, um dementsprechend Luft-Flüssigkeits-Wärmetauscher mit unterschiedlicher Kühlleistung aufzunehmen. Am unteren Ende des Luft-Flüssigkeits-Wärmetauschers 11 ist jeweils eine Kondensatwanne 26 vorgesehen, um das versehentliche Eindringen von Kondensat in den Schaltschrankinnenraum zu verhindern.

Die Lüfter 21 sind als Axial-EC-Lüfter mit saugseitigem Gitterrost als Berührungsschutz mit gleichzeitiger Luftgleichrichtungsfunktion ausgebildet. Die Kondensatwanne 26 kann einen Leckagesensor aufweisen. Die Wärmetauscher 11 sind für hohe Vorlauftemperaturen ausgelegt und insbesondere für die Verwendung von Glykol oder eines Glykol-Wasser-Gemischs als Kühlmittel. Mithilfe von Jalousieklappenmodulen 24 wird das Zurückströmen von Kühlluft in den Raum 1 (siehe Figur 1) vermieden, wenn die Lüfter stillstehen. Wie bereits oben beschreiben, kann das Jalousieklappenmodul beispielsweise fremdenergielos angesteuerte "Flatterjalousien" oder Jalousieklappen mit Stellantrieb umfassen.

Die Schaltschränke 2 und das Gehäuse 15 können ein einheitliches Rahmengestell mit über die gesamte Höhe von Schaltschrank 2 und Gehäuse 15 erstreckenden Vertikalprofilen aufweisen. Alternativ ist auch denkbar, dass der Schaltschrank 2 und das Gehäuse 15 jeweils ein eigenes Rahmengestell aufweisen, die miteinander verschraubt sind. Weiterhin ist auch denkbar, dass das Gehäuse 15 als eine selbsttragende Struktur aus gekannten Blechflachteilen ausgebildet ist, die so mit dem Rahmengestell des darunter liegenden Schaltschranks 2 verschraubt ist, dass die Last des Kühlgehäuses 15 im Wesentlichen ausschließlich auf die vertikalen Profilstreben des Rahmengestells des Schaltschranks 2 senkrecht eingeleitet wird.

### Bezugszeichenliste:

- 1: Raum des Rechenzentrums
- 2: Schaltschrank
- 3: Schaltschrankreihe
- 4: Kühlgerät
- 5: Doppelboden
- 6: Kaltgang
- 7: Dem Kaltgang zugewandte Vertikalseite
- 8: Dem Kaltgang abgewandte Vertikalseite
- 9: Rückkühler
- 10: Oberseite
- 11: Zweiter Luft-Flüssigkeits-Wärmetauscher
- 12: Warmluft
- 13: Gekühlte Luft
- 14: Kühlmittelquelle
- 15.: Kühlgehäuse
- 16, 17: Gegenüberliegende Gehäuseseiten
- 18: Kaltgangschottung
- 19: Dachseite
- 20: Kabelrangierraum
- 21: Lüfter
- 22: Warmlufteinlass
- 23: Kaltluftauslass
- 24: Vorrichtung zur Vermeidung eines Zurückströmen von gekühlter Luft
- 25: Dreiwegeventil
- 26: Kondensatwanne
- d: Abstand

## Patentansprüche

1. Rechenzentrum, bei dem in einem geschlossenen Raum (1) eine Mehrzahl aus jeweils mehreren Schaltschränken (2) gebildeter Schaltschrankreihen (3) sowie mindestens ein Kühlgerät (4) auf einem Doppelboden (5) aufgestellt sind, in den über das Kühlgerät (4) gekühlte Raumluft eingeleitet ist, wobei zwischen zwei benachbarten Schaltschrankreihen (3) ein gegenüber dem Raum (1) luftdicht abgeschotteter Kaltgang (6) gebildet ist, dem die gekühlte Luft aus dem Doppelboden (5) zugeführt ist, wobei den Schaltschränken (2) der benachbarten Schaltschrankreihen (3) jeweils an ihren dem Kaltgang (6) zugwandten Vertikalseiten (7) die gekühlte Luft zugeleitet ist, die als erwärmte Luft an gegenüber liegenden, dem Kaltgang (6) abgewandten Vertikalseiten (8) der Schaltschränke (2) in den geschlossenen Raum (1) abgeleitet ist, und wobei das Kühlgerät (4) einen ersten Luft-Flüssigkeit-Wärmetauscher aufweist, dem ein über mindestens einen außerhalb des Raums (1) angeordneten Rückkühler (9) gekühltes Kühlmittel zugeleitet ist, **dadurch gekennzeichnet, dass** mindestens einer der Schaltschränke (2) einen unmittelbar auf seiner Oberseite (10) oder unter einem Abstand (d) dazu montierten zweiten Luft-Flüssigkeits-Wärmetauscher (11) aufweist, durch den Warmluft (12) aus dem Raum (1) als gekühlte Luft (13) in den Kaltgang (6) geleitet ist, wobei dem zweiten Luft-Flüssigkeits-Wärmetauscher (11) über eine außerhalb des Raums (1) angeordnete Kühlmittelquelle (14) gekühltes Kühlmittel zugeleitet ist, wobei der zweite Luft-Flüssigkeits-Wärmetauscher (11) in einem auf der Oberseite (10) des betreffenden Schaltschranks (2) montierten Kühlgehäuse (15) aufgenommen ist, wobei durch gegenüber liegende Gehäuseseiten (16, 17) des Kühlgehäuses (15) die Warmluft (12) aus dem Raum (1) durch das Kühlgehäuse (15) und als gekühlte Luft (13) in den Kaltgang (6) geleitet ist, und wobei in dem Kühlgehäuse (15) mindestens ein drehzahlgeregelter Lüfter (21) aufgenommen ist, wobei an einem Warmlufteinlass (22) und/oder an einem Kaltluftauslass (23) des Kühlgehäuses (15) eine Vorrichtung (24), etwa eine Rückstauklappe oder ein Jalousieklappenmodul, angeordnet ist, welche dazu eingerichtet ist, ein Zurückströmen von gekühlte Luft (13) aus dem Kaltgang (6) in den Raum (1) zu verhindern.

2. Rechenzentrum nach Anspruch 1, bei dem mindestens einer der Rückkühler (9) ein Freikühler ist.

3. Rechenzentrum nach Anspruch 1 oder 2, bei dem die Kühlmittelquelle (14) einen Rückkühler und/oder einen Kaltwassersatz aufweist.

4. Rechenzentrum nach Anspruch 1, bei dem nur eine der beiden benachbarten, den Kaltgang (6) zwischen sich bildenden Schaltschrankreihen (3) mindestens einen Schaltschrank (2) mit auf seiner Oberseite (10) montiertem zweiten Luft-Flüssigkeits-Wärmetauscher (11) aufweist, wobei die den Kaltgang (6) bildenden Schaltschrankreihen (3) im Wesentlichen dieselbe Höhe aufweisen, und wobei eine Kaltgangschottung (18) zumindest abschnittsweise eine Höhe aufweist, die mindestens der Gesamthöhe aus Schaltschrankhöhe und Kühlgehäusehöhe entspricht.

5. Rechenzentrum nach Anspruch 4, bei dem die Kaltgangschottung (18) die obere Dachseite (19) des Kühlgehäuses (15) mit der Oberseite (10) der gegenüber liegenden Schaltschrankreihe (3) fluidisch dicht verbindet.

6. Rechenzentrum nach Anspruch 1, bei dem der das Kühlgehäuse (15) aufweisende Schaltschrank (2) sowie das Kühlgehäuse (15) ein aus vier Vertikalstreben und acht Horizontalstreben gebildetes Rahmengestell aufweisen, wobei sich die Vertikalstreben über die Gesamthöhe aus Schaltschrank (2) und Kühlgehäuse (15) erstrecken.

7. Rechenzentrum nach Anspruch 1, bei dem das Kühlgehäuse (15) unter einem Abstand zu der Oberseite (10) des Schaltschranks (2) angeordnet ist, so dass zwischen der Oberseite (10) des Schaltschranks (2) und dem Kühlgehäuse (15) ein Kabelrangierraum (20) für eine Kabelzuführung durch die Oberseite (10) des Schaltschranks (2) ausgebildet ist.

8. Rechenzentrum nach einem der vorangegangenen Ansprüche, bei dem die Kühlmittelquelle (14) mindestens einen Rückkühler und mindestens einen Kaltwassersatz aufweist, die über ein Dreiwegeventil (25) oder dergleichen fluidisch mit dem zweiten Luft-Flüssigkeits-Wärmetauscher (11) verbunden sind.

9. Rechenzentrum nach Anspruch 1, bei dem das Kühlgehäuse (15) an seiner Luftausströmseite für gekühlte Luft (13) eine Luftleitgeometrie aufweist, über die die aus dem Kühlgehäuse (15) in den Kaltgang (6) einströmende, gekühlte Luft vor die benachbarte Schaltschrankreihe (3) geblasen ist.

10. Rechenzentrum nach einem der vorangegangenen Ansprüche, bei dem der Raum (1) eine Deckenhöhe aufweist, die nur unwesentlich höher als die Höhe der kombinierten Einheit aus Schaltschrank (2) und darauf montiertem, zweiten Luft-Flüssigkeits-Wärmetauscher (11) ist, so dass durch den zweiten Luft-Flüssigkeits-Wärmetauscher (11) Luft eines unter der Raumdecke stehenden Warmluftpolsters geleitet ist.

## Claims

1. A data center, in which, in a closed room (1), a plurality of rows of switch cabinets (3), each formed from multiple switch cabinets (2), and at least one cooling device (4) are placed on a double floor (5), into which room air cooled via the cooling device (4) is passed, wherein a cold aisle (6), which is hermetically sealed off from the room (1), is formed between two adjacent rows of switch cabinets (3), into which cold aisle the cooled air from the double floor (5) is fed, wherein the cooled air is supplied to the switch cabinets (2) of the adjacent rows of switch cabinets (3) each at their vertical sides (7) facing the cold aisle (6) and is discharged into the closed room (1) as heated air at opposite vertical sides (8) of the switch cabinets (2) facing away from the cold aisle (6), and wherein the cooling device (4) comprises a first air-liquid heat exchanger to which a coolant cooled by at least one recooler (9) arranged outside the room (1) is supplied, **characterized in that** at least one of the switch cabinets (2) has a second air-liquid heat exchanger (11) which is mounted directly on its top side (10) or at a distance (d) therefrom, via which warm air (12) from the room (1) is fed as cooled air (13) into the cold aisle (6), wherein cooled coolant is supplied to the second air-liquid heat exchanger (11) via a coolant source (14) arranged outside the room (1), wherein the second air-liquid heat exchanger (11) is accommodated in a cooling housing (15) mounted on the top side (10) of the respective switch cabinet (2), wherein through opposite housing sides (16, 17) of the cooling housing (15) the warm air (12) from the room (1) is conducted through the cooling housing (15) and into the cold aisle (6) as cooled air (13), and wherein at least one speed-controlled fan (21) is accommodated in the cooling housing (15), wherein at a warm air inlet (22) and/or at a cold air outlet (23) of the cooling housing (15) a device (24), such as a backflow flap or a louvered flap module, is arranged, which is configured to prevent a backflow of cooled air (13) from the cold aisle (6) into the room (1).

2. The data center according to claim 1, in which at least one of the recoolers (9) is a free cooler.

3. The data center according to claim 1 or 2, in which the coolant source (14) comprises a recooler and/or a water chiller.

4. The data center according to claim 1, in which only one of the two adjacent rows of switch cabinets (3) forming the cold aisle (6) between them has at least one switch cabinet (2) with a second air-liquid heat exchanger (11) mounted on its top side (10), wherein the rows of switch cabinets (3) forming the cold aisle (6) have substantially the same height, and wherein a cold aisle partitioning (18) has, at least in sections, a height which corresponds at least to the total height of switch cabinet height and cooling housing height.

5. The data center according to claim 4, in which the cold aisle partition (18) connects the upper roof side (19) of the cooling housing (15) with the top side (10) of the opposite row of switch cabinets (3) in a fluidically tight manner.

6. The data center according to claim 1, in which the switch cabinet (2) having the cooling housing (15) and the cooling housing (15) have a frame formed from four vertical struts and eight horizontal struts, the vertical struts extending over the total height of switch cabinet (2) and cooling housing (15).

7. The data center according to claim 1, in which the cooling housing (15) is arranged at a distance from the top side (10) of the switch cabinet (2), so that between the top side (10) of the switch cabinet (2) and the cooling housing (15) a cable routing space (20) is formed for a cable feed through the top side (10) of the switch cabinet (2).

8. The data center according to any one of the preceding claims, in which the coolant source (14) comprises at least one recooler and at least one water chiller, which are fluidically connected to the second air-liquid heat exchanger (11) via a three-way valve (25) or the like.

9. The data center according to claim 1, in which the cooling housing (15) has on its air discharge side for cooled air (13) an air guiding geometry via which the cooled air flowing from the cooling housing (15) into the cold aisle (6) is blown in front of the adjacent row of switch cabinets (3).

10. The data center according to any one of the preceding claims, in which the room (1) has a ceiling height which is only insignificantly higher than the height of the combined unit of switch cabinet (2) and second air-liquid heat exchanger (11) mounted thereon, so that air of a warm air cushion located under the room ceiling is conducted through the second air-liquid heat exchanger (11).

## Revendications

1. Centre de calcul, dans lequel, dans un local (1) fermé, sont installés une pluralité de rangées d'armoires de commande (3) formées de respectivement plusieurs armoires de commande (2) ainsi qu'au moins un appareil de refroidissement (4) sur un faux plancher (5) dans lequel de l'air ambiant refroidi par le biais de l'appareil de refroidissement (4) est introduit, une aile froide (6) cloisonnée de manière étanche à l'air vis-à-vis du local (1) étant formée entre deux rangées d'armoires de commande (3) voisines, aile froide (6) à laquelle est conduit l'air refroidi en provenance du faux plancher (5), l'air refroidi étant acheminé aux armoires de commande (2) des rangées d'armoires de commande (3) voisines respectivement sur leurs côtés verticaux (7) tournés vers l'aile froide (6), air refroidi qui est détourné vers le local (1) fermé en tant qu'air réchauffé sur des côtés verticaux (8) des armoires de commande (2) opposés et éloignés de l'aile froide (6), et l'appareil de refroidissement (4) comportant un premier échangeur de chaleur air-liquide auquel est acheminé un produit réfrigérant refroidi par le biais d'au moins un refroidisseur de retour (9) disposé à l'extérieur du local (1), **caractérisé en ce qu'**au moins l'une des armoires de commande (2) comporte un deuxième échangeur de chaleur air-liquide (11) monté directement sur le côté supérieur (10) de celle-ci ou à une distance (d) de celle-ci et à travers lequel de l'air chaud (12) en provenance du local (1) est conduit en tant qu'air refroidi (13) dans l'aile froide (6), du produit réfrigérant refroidi étant acheminé au deuxième échangeur de chaleur air-liquide (11) par le biais d'une source de produit réfrigérant (14) disposée à l'extérieur du local (1), le deuxième échangeur de chaleur air-liquide (11) étant logé dans un carter de refroidissement (15) monté sur le côté supérieur (10) de l'armoire de commande (2) concerné, l'air chaud (12) étant, à travers des côtés de carter (16, 17) opposés du carter de refroidissement (15), conduit à partir du local (1) à travers le carter de refroidissement (15) et, en tant qu'air refroidi (13), dans l'aile froide (6), et au moins un ventilateur (21) à vitesse de rotation réglée étant logé dans le carter de refroidissement (15), un dispositif (24), par exemple un clapet antiretour ou un module de clapet à jalousie, étant disposé sur une entrée d'air chaud (22) et/ou sur une sortie d'air froid (23) du carter de refroidissement (15), ce dispositif étant agencé pour empêcher un écoulement en retour de l'air refroidi (13) à partir de l'aile froide (6) vers le local (1).

2. Centre de calcul selon la revendication 1, dans lequel au moins l'un des refroidisseurs de retour (9) est un refroidisseur naturel.

3. Centre de calcul selon la revendication 1 ou 2, dans lequel la source de produit réfrigérant (14) comporte un refroidisseur de retour et/ou un groupe d'eau glacée.

4. Centre de calcul selon la revendication 1, dans lequel seule l'une des deux rangées d'armoires de commande (3) voisines, formant entre elles l'aile froide (6), comporte au moins une armoire de commande (2) avec le deuxième échangeur de chaleur air-liquide (11) monté sur son côté supérieur (10), les rangées d'armoires de commande (3) formant l'aile froide (6) présentant essentiellement la même hauteur, et un cloisonnement d'aile froide (18) présentant au moins par tronçons une hauteur qui correspond au moins à la hauteur totale composée de la hauteur d'armoire de commande et de la hauteur du carter de refroidissement.

5. Centre de calcul selon la revendication 4, dans lequel le cloisonnement d'aile froide (18) raccorde de façon étanche aux fluides le côté de toit (19) supérieur du carter de refroidissement (15) au côté supérieur (10) de la rangée d'armoires de commande (3) située en face.

6. Centre de calcul selon la revendication 1, dans lequel l'armoire de commande (2) comportant le carter de refroidissement (15) ainsi que le carter de refroidissement (15) comportent un châssis-cadre formé de quatre entretoises verticales et de huit entretoises horizontales, les entretoises verticales s'étendant sur la hauteur totale composée de l'armoire de commande (2) et du carter de refroidissement (15).

7. Centre de calcul selon la revendication 1, dans lequel le carter de refroidissement (15) est disposé à distance du côté supérieur (10) de l'armoire de commande (2) de telle sorte que, entre le côté supérieur (10) de l'armoire de commande (2) et le carter de refroidissement (15), il est constitué un espace de rangement de câbles (20) pour un passage de câbles à travers le côté supérieur (10) de l'armoire de commande (2).

8. Centre de calcul selon l'une des revendications précédentes, dans lequel la source de produit réfrigérant (14) comporte au moins un refroidisseur de retour et au moins un groupe d'eau glacée qui sont raccordés par liaison fluidique au deuxième échangeur de chaleur air-liquide (11) par le biais d'une vanne trois voies (25) ou similaire.

9. Centre de calcul selon la revendication 1, dans lequel, sur son côté de sortie d'air pour l'air refroidi (13), le carter de refroidissement (15) présente une géométrie de guidage d'air par le biais de laquelle l'air refroidi entrant dans l'aile froide (6) en provenance du carter de refroidissement (15) est soufflé avant la rangée d'armoires de commande (3) voisine.

10. Centre de calcul selon l'une des revendications précédentes, dans lequel le local (1) présente une hauteur de plafond qui n'est que légèrement plus élevée que la hauteur de l'unité combinée composée de l'armoire de commande (2) et du deuxième échangeur de chaleur air-liquide (11) qui est monté dessus de telle sorte que de l'air d'un coussin d'air chaud placé sous le plafond du local est guidé à travers l'échangeur de chaleur de couplage (11).
